# EUROPÄISCHE PATENTSCHRIFT

(11) **EP 0 844 946 B1**
(45) Veröffentlichungstag und Bekanntmachung des Hinweises auf die Patenterteilung: **10.10.2001**
(21) Anmeldenummer: 96911927.0
(22) Anmeldetag: 27.04.1996
(51) Int. Cl.: B60R 21/00, B60R 16/02, G01R 27/00, G01R 31/00

(54) **ANORDNUNG ZUM ÜBERPRÜFEN DES WIDERSTANDES EINER AN EINEM ÜBERTRAGER ANGESCHLOSSENEN LAST**
SYSTEM FOR CHECKING THE RESISTANCE OF A LOAD CONNECTED TO A TRANSFORMER
SYSTEME DE CONTROLE DE LA RESISTANCE D'UNE CHARGE RACCORDEE A UN TRANSFORMATEUR

(30) Priorität: 19.08.1995 DE 19530587
(43) Veröffentlichungstag der Anmeldung: 03.06.1998
(73) Patentinhaber: ROBERT BOSCH GMBH, 70442 Stuttgart (DE)
(72) Erfinder: ZABLER, Erich, D-76297 Stutensee (DE); DUKART, Anton, D-76744 Wörth (DE); HERRMANN, Thomas, D-74243 Langenbrettch (DE)
(86) Internationale Anmeldenummer: DE9600738
(87) Internationale Veröffentlichungsnummer: WO9706979

(56) Entgegenhaltungen:
- DE-A- 2 433 555
- DE-C- 3 812 631
- FR-A- 2 576 109

## Beschreibung

### Stand der Technik

Die vorliegende Erfindung betrifft eine Anordnung zum Überprüfen des Widerstandes einer an einem Übertrager sekundärseitig angeschlossenen Last - vorzugsweise der Zündpille eines Airbags- gemäß den Merkmalen des Oberbegriffs des Anspruchs 1.

Eine derartige Anordnung zum Überprüfen des Zündpillenwiderstandes an der Sekundärseite eines Drehübertragers ist aus der DE 38 12 633 A1 bekannt. Gemäß diesem Stand der Technik wird beispielsweise zur Signalübertragung zwischen einem Steuergerät und einem in einem Lenkrad eines Fahrzeugs eingebauten Airbag ein Drehübertrager verwendet. Die Funktionsfähigkeit eines Airbags ist ständig zu überprüfen, damit er in jeder Notfallsituation sofort einsatzbereit ist. Dazu wird der Widerstandswert der Zündpille, der im Bereich von 1,8 Ω bis 2,5 Ω liegen soll, einer ständig wiederkehrenden Messung unterzogen. Die Übertragung von Signalen mittels der induktiv gekoppelten Wicklungen des Drehübertragers ist vom Abstand der beiden Wicklungen, d. h., der Größe des Luftspalts zwischen den Schalenkernen der Wicklungen, abhängig. Einbau- und Fertigungstoleranzen des Lenkrades, an dem der sekundärseitige Schalenkern des Drehübertragers installiert ist, können zu einer Verfälschung des gemessenen Widerstandswertes der Zündpille führen. Um solche Meßsignalverfälschungen zu vermeiden, sieht der genannte Stand der Technik einen Schwingkreis auf der Sekundärseite des Drehübertragers vor, der von der Primärseite aus von einem Steuersignal angeregt wird. Nach Abschalten des Steuersignals wird das abklingende Antwortsignal des Schwingkreises auf die Primärseite zurückübertragen und aus der Zeitkonstante des abklingenden Antwortsignals der sekundärseitige Widerstand ermittelt.

Um den Zustand einer an der Sekundärseite eines Drehübertragers angeschlossenen Zündpille für ein Sicherheitssystem (z. B. Airbag) überprüfen zu können, ist gemäß der DE 38 12 631 C1 auf der Sekundärseite ein Meßwiderstand anschaltbar, der dem Zündpillenwiderstand entspricht. Sowohl die Zündpille als auch der Meßwiderstand sind getrennt voneinander durch jeweils einen Schalter an die Sekundärseite des Übertragers an- oder von ihr abschaltbar. Zündpille und Meßwiderstand werden mittels der Schalter alternierend an- und abgeschaltet. Dabei wird an der Primärseite des Übertragers die Spannung bei angeschalteter Zündpille und die Spannung bei angeschaltetem Meßwiderstand erfaßt, und beide Spannungen werden miteinander verglichen. Im fehlerfreien Fall müßten beide Spannungen wegen gleicher Widerstandswerte der Zündpille und des Meßwiderstandes gleich groß sein. Falls sich eine Abweichung zwischen den Spannungen einstellt, wird ein Fehler signalisiert.

Bei dieser bekannten Meßmethode wird die Zündpille periodisch von der Sekundärseite des Übertragers abgeschaltet. Es entstehen also Phasen, in denen im Falle eine Unfalls kein Zündimpuls an die Zündpille gelangen kann, eine Airbagauslösung also verhindert wird.

Der Erfindung liegt daher die Aufgabe zugrunde, eine Anordnung zum Überprüfen des Widerstandes einer an einem Übertrager sekundärseitig angeschlossenen Last - vorzugsweise einer Airbagzündpille - anzugeben, bei der die Funktion der Last während des Prüfungsvorgangs nicht unterbrochen wird.

### Vorteile der Erfindung

Gemäß Anspruch 1 findet eine Überprüfung des Widerstandes einer an einem Übertrager sekundärseitig angeschlossenen Last - vorzugsweise der Zündpille eines Airbags - mittels eines definierten Meßwiderstandes statt, der zu der Last hinzuschaltbar ist. Die durch das Hinzuschalten des Meßwiderstandes erfolgende Änderung des sekundärseitigen Gesamtwiderstandes wird registriert und es erfolgt, wenn die Widerstandsänderung von einem vorgegebenen Wert abweicht, eine entsprechende Signalisierung.

Der dem Anspruch 1 zugrunde liegende Lösungsansatz für die Überprüfung der sekundärseitig an einen Übertrager angeschlossenen Last benötigt lediglich einen zusätzlich auf der Sekundärseite des Übertragers vorgesehenen Meßwiderstand, der zur Last hinzugeschaltet werden kann. Die Anordnung ist also mit einem sehr geringen Schaltungsaufwand realisierbar. Zweckmäßige Weiterbildungen der Anordnungen nach Anspruch 1 gehen aus den Unteransprüchen hervor.

### Beschreibung eines Ausführungsbeispiels

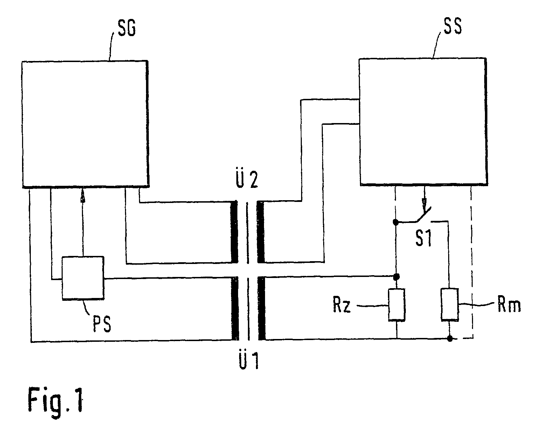

Anhand eines in der Zeichnung dargestellten Ausführungsbeispiels wird nachfolgend die Erfindung näher erläutert. Figur 1 zeigt eine Schaltungsanordnung zur Erfassung einer Widerstandsänderung einer sekundärseitig an einen Übertrager angeschlossenen Last durch Parallelschalten eines definierten Messwiderstandes.

Die Schaltung in Figur 1 weist einen ersten Übertrager Ü1 auf, dessen Sekundärseite mit einer Last beschaltet ist, die den ohmschen Widerstand Rz hat. Dieser Übertrager Ü1 sei beispielsweise ein Drehübertrager, der zwischen einem mit einem Airbag ausgestatteten Lenkrad und der feststehenden Lenksäule angeordnet ist. Die sekundärseitig angeschlossene Last entspricht dann dem Widerstand Rz einer Zündpille des Airbags, und die Primärseite des Übertragers Ü1 ist an ein mit dem Fahrzeugchassis verbundenes Steuergerät SG angeschlossen. Dieses Steuergerät SG gibt bei einem Unfall des Fahrzeugs ein Auslösesignal für die Zündpille des Airbags ab.

Wie bereits oben ausgeführt, muss die Zündpille (einschließlich der Leitung vom Übertrager zur Zündpille) ständig auf Funktionssicherheit überprüft werden. Dazu wird der Widerstand Rz der Zündpille in gewissen Zeitabständen immer wieder gemessen und kontrolliert, ob er einen vorgegebenen Wert beibehält oder nicht. Eine Abweichung von diesem vorgegebenen Widerstandswert deutet darauf hin, dass die Funktion des Airbags gestört ist. Eine solche Situation muss im Fahrzeug signalisiert werden. Um Änderungen des Widerstandes Rz der Zündpille mit großer Zuverlässigkeit registrieren zu können, ist ein Messwiderstand Rm vorgesehen, der vorzugsweise dem Zündpillenwiderstand Rz mittels eines Schalters S1 parallelgeschaltet werden kann. Dieser Messwiderstand Rm hat einen vorgegebenen konstanten Wert, zweckmäßigerweise ist er ca. vier- bis fünfmal so groß wie der Zündpillenwiderstand Rz. Damit ist gewährleistet, dass, falls der Schalter defekt ist und nicht mehr geöffnet werden kann, bei Auslösung des Airbagsnur ein Viertel oder ein Fünftel der Zündenergie auf der Sekundärseite des Übertragers Ü1 in dem hinzugeschalteten Messwiderstand Rm verlorengeht, so daß auf jeden Fall die in die Zündpille induzierte Energie für das Auslösen des Airbags ausreicht. Durch das Hinzuschalten des Messwiderstandes Rm ändert sich der sekundärseitig an den Übertrager 1 angeschlossene Gesamtwiderstand aus dem Zündpillenwiderstand Rz und dem Messwiderstand Rm um einen ganz bestimmten Wert, wenn der Zündpillenwiderstand Rz seinen bekannten, eine sichere Funktion des Airbags garantierten Wert hat. Weicht die Widerstandsänderung bei Hinzuschalten des Messwiderstandes Rm von dem vorgegebenen Wert ab, so ist eine Störung zu signalisieren. Die Überprüfung des Zündpillenwiderstandes Rz läuft also so ab, dass von Zeit zu Zeit der Messwiderstand Rm hinzugeschaltet wird und die daraus resultierende Widerstandsänderung registriert wird. Auf diese Weise können verfälschende Einflüsse durch Temperatur und mechanische Toleranzen, die eine absolute Erfassung des Lastwiderstandes Rz unmöglich machen, eliminiert werden. Eine sekundärseitig, z. B. im Lenkrad, installierte Schaltung SS betätigt den Schalter S1 zum Ein- und Abschalten des Messwiderstandes Rm. Ein Aufforderungssignal für die Schalterbetätigung erhält die Schaltung SS über einen zweiten Drehübertrager Ü2 von der primärseitig angeschlossenen Steuerschaltung SG. Die Messung des sekundärseitigen Gesamtwiderstandes bei eingeschaltetem Messwiderstand Rm kann, wie durch die strichlierten Signalpfeile angedeutet, in der sekundärseitigen Schaltung SS (z. B. mit einer Widerstandsmessbrücke) erfolgen. Das Messergebnis kann dann wiederum über den zweiten Drehübertrager Ü2 an die Steuerschaltung SG zurückübertragen werden, welche dann bei einer unzulässigen Widerstandsänderung eine Störung signalisiert. Durch die Verwendung von zwei Übertragern sind der Zündkreis und der Diagnosekreis voneinander getrennt.

Die Widerstandsänderung durch das Hinzuschalten des Messwiderstandes Rm macht sich aber auch als eine entsprechende Änderung des Stromes im Primärkreis des Übertragers bemerkbar. Eine in den Primärkreis des Übertragers Ü1 eingefügte Schaltung PS nimmt Änderungen des Primärstromes, wenn der Messwiderstand Rm hinzugeschaltet wird, wahr und gibt sie an die Steuerschaltung SG weiter. Beispielsweise durch eine Schwellwertbetrachtung entscheidet die Steuerschaltung SG, ob die Änderung des Primärstromes von einem vorgegebenen Wert abweicht. Wenn das der Fall ist, was gleichbedeutend ist mit einer unzulässigen Änderung des Zündpillenwiderstandes Rz, wird ein eine Störung anzeigendes Signal ausgelöst.

Abweichend von der Airbag-Anwendung lassen sich die zuvor beschriebenen Schaltungen auch zur Überprüfung anderer an die Sekundärseite eines Übertragers angeschlossener Lastwiderstände überprüfen, z. B. einer Hupe oder von Bedienelementen eines Radios oder Telefons, welche am Lenkrad angeordnet sind.

## Patentansprüche

1. Anordnung zum Überprüfen des Widerstandes einer an einem Übertrager (Ü1) sekundärseitig angeschlossenen Last (Rz) - vorzugsweise der Zündpille eines Airbags-, wobei ein Messwiderstand (Rm) vorgesehen ist, der an die Sekundärseite des Übertragers (Ü1) schaltbar ist, **dadurch gekennzeichnet, dass** Mittel (SS, PS) vorgesehen sind, welche die durch ein Hinzuschalten des Messwiderstandes (Rm) zur Last (Rz) erfolgende Widerstandsänderung registrieren und signalisieren, wenn die Widerstandsänderung von einem vorgebbaren Wert abweicht.

2. Anordnung nach Anspruch 1, **dadurch gekennzeichnet, daß** der Meßwiderstand (Rm) zur Last (Rz) an der Sekundärseite des Übertragers (Ü1) parallel schaltbar ist.

3. Anordnung nach Anspruch 2, **dadurch gekennzeichnet, daß** der Meßwiderstand (Rm) vier- bis fünfmal so groß ist wie der Widerstand (Rz) der Last.

4. Anordnung nach Anspruch 1 oder 2, **dadurch gekennzeichnet, daß** eine Widerstandsmeßschaltung (SS) vorgesehen ist, welche den Gesamtwiderstand aus Last (Rz) und Meßwiderstand (Rm) mißt.

5. Anordnung nach Anspruch 1 oder 2, **dadurch gekennzeichnet, daß** eine Einrichtung (PS) vorgesehen ist, welche beim Hinzuschalten des Meßwiderstandes (Rm) die dadurch verursachte Veränderung des Stromes auf der Primärseite des Übertragers (Ü1) registriert.

## Claims

1. Arrangement for checking the resistance of a load (Rz) - preferably the firing pellet of an airbag - connected to the secondary side of a transformer (Ü1), a measuring resistor (Rm) being provided which can be connected to the secondary side of the transformer (Ü1), **characterized in that** means (SS, PS) are provided which register the change in resistance that takes place as a result of the measuring resistor (Rm) being supplementarily connected to the load (Rz), and signal when the change in resistance deviates from a predeterminable value.

2. Arrangement according to Claim 1, **characterized in that** the measuring resistor (Rm) can be connected in parallel with the load (Rz) on the secondary side of the transformer (Ü1).

3. Arrangement according to Claim 2, **characterized in that** the measuring resistor (Rm) is four to five times as large as the resistance (Rz) of the load.

4. Arrangement according to Claim 1 or 2, **characterized in that** a resistance measuring circuit (SS) is provided which measures the total resistance of load (Rz) and measuring resistor (Rm).

5. Arrangement according to Claim 1 or 2, **characterized in that** a device (PS) is provided which, when the measuring resistor (Rm) is supplementarily connected, registers the change that this causes in the current on the primary side of the transformer (Ü1).

## Revendications

1. Système de contrôle de la résistance d'une charge (Rz) raccordée au secondaire d'un transformateur (Ü1), de préférence la pastille fulminante d'un airbag, dans lequel une résistance de mesure (Rm) peut être connectée au secondaire du transformateur (Ü1),
**caractérisé en ce qu'**
il est prévu des moyens (SS, PS) qui enregistrent la variation de résistance résultant de la connexion de la résistance de mesure (Rm) à la charge (Rz), et qui émettent un signal si cette variation s'écarte d'une valeur donnée à l'avance.

2. Système selon la revendication 1,
**caractérisé en ce que**
la résistance de mesure (Rm) peut être connectée à la charge (Rz) en parallèle sur le côté secondaire du transformateur.

3. Système selon la revendication 2,
**caractérisé en ce que**
la résistance de mesure (Rm) est quatre à vingt fois plus grande que la résistance (Rz) de la charge.

4. Système selon la revendication 1 ou 2,
**caractérisé en ce qu'**
il est prévu un circuit de mesure de résistance (SS) qui mesure la résistance totale composée de la charge (Rz) et de la résistance de mesure (Rm).

5. Système selon la revendication 1 ou 2,
**caractérisé en ce qu'**
il est prévu un dispositif (PS) qui, quand on connecte la résistance de mesure (Rm) enregistre la variation ainsi produite du courant du côté primaire du transformateur (Ü1).
